Europäisches Patentamt

(19) European Patent Office

Office européen des brevets

(11) Veröffentlichungsnummer: **0 201 593**
**B1**

(12) ## EUROPÄISCHE PATENTSCHRIFT

(45) Veröffentlichungstag der Patentschrifft:
28.02.90

(51) Int. Cl. ⁵: **G 01 R 21/00**

(21) Anmeldenummer: **85906031.1**

(22) Anmeldetag: **13.11.85**

(86) Internationale Anmeldenummer:
**PCT/DE 85/00471**

(87) Internationale Veröffentlichungsnummer:
**WO 86/03013 (22.05.86 Gazette 86/11)**

(54) ELEKTRISCHES MESSVERFAHREN.

(30) Priorität: **15.11.84 DE 3441720**

(43) Veröffentlichungstag der Anmeldung:
**20.11.86 Patentblatt 86/47**

(45) Bekanntmachung des Hinweises auf die Patenterteilung:
**28.02.90 Patentblatt 90/09**

(84) Bennante Vertragsstaaten:
**AT BE CH DE FR GB IT LI LU NL SE**

(56) Entgegenhaltungen:
**DE-A-3 017 816**
**GB-A-2 058 416**
**US-A-3 562 647**

(73) Patentinhaber: **Hanning Elektro-Werke GmbH & Co.**
**Holter Strasse 90**
**D-4811 Oerlinghausen (DE)**

(72) Erfinder: **GABRIEL, Rupprecht**
**Albert-Schweitzer-Strasse 47b**
**D-4811 Oerlinghausen (DE)**
Erfinder: **KIEL, Edwin**
**Kurzekampstrasse 3**
**D-3300 Braunschweig (DE)**
Erfinder: **SCHUMACHER, Walter**
**Petritorwall 30**
**D-3300 Braunschweig (DE)**

(74) Vertreter: **Hentzschel, Hans-Jürgen**
**In der Feldmark 3**
**D-4970 Bad Oeynhausen 1 (DE)**

LIBERGRAF, STOCKHOLM 1990

EP 0 201 593 B1

## Beschreibung

Die Erfindung betrifft ein elektrisches Meßverfahren zur vergleichenden Bestimmung des Leistungsfaktors eines von einer stationären oder ortsveränderlichen Spannungsquelle über einen Umrichter gespeisten Drehstrommotors und einer in wenigstens einem Schaltzweig angeordneten Strommeßeinrichtung, die über einen Schalter mit einem Integrator oder ähnlich wirkenden Filter, dessen Ausgangssignal ein Maß für den Leistungsfaktor des Drehstrommotors darstellt, verbunden ist. Nach diesem Verfahren arbeitende, im Rahmen einer Reihe von Steuer-, Regel- und Überwachungszwecken benötigten Meßanordnungen werden beispielsweise als Überwachungseinrichtungen für das Kippen des Motors, Leistungsfaktorregelungen usw. eingesetzt.

Aus Schenk/Tietze "Halbleiter-Schaltungstechnik", Springer-Verlag 1983, Seite 819 - 824, sowie den DE-B-1 541 896 und DE-B-2 220 241 sind Anordnungen zur vergleichenden Phasenwinkelbestimmung bekannt. Damit läßt sich der Leistungsfaktor oder cos-phi aus den Spannungs- und Stromverläufen an den Motorklemmen bestimmen. Für die spezifischen Aufgaben in umrichtergespeisten Antrieben mit ihren, wegen der schaltenden Arbeitsweise der Umrichter oberschwingungsbehafteten Signalformen, mit teilweise mehrfachen Nulldurchgängen, sind solche Anordnungen jedoch störanfällig und daher weniger gut geeignet. Ebenso scheiden Filteranordnungen hinsichtlich des großen Frequenzbereiches des Umrichters aus. Auch die erforderliche potentialtrennende Messung des Motorstromes ist mit erheblichem Aufwand verbunden.

Eine Möglichkeit zur Regelung des Leistungsfaktors von umrichtergespeisten Antrieben wird in der DE-C-3 030 694 beschrieben. Sie benutzt eine Meßeinrichtung, die nicht den Motorklemmenstrom, sondern den Zwischenkreisstrom mißt. Prinzipbedingt ist dieses Verfahren aber nur für Umrichter mit blockförmiger Ausgangsspannung bzw. blockförmigem Strom, nicht aber für Pulsumrichter ohne umfangreiche Erweiterungen nutzbar. Der Grund hierfür liegt darin, daß bei Pulsumrichtern die Ausgangsspannung mittels Pulsbreitenmodulation variiert wird. Dadurch wird beim Einschalten des Nullvektors der Blindstrom nicht über den Zwischenkreis geschaltet und ist dort auch nicht meßbar. Noch weitaus schwierigere Verhältnisse kommen im Falle sinusbewerteter Modulation zustande.

Eine in der DE-A-3 017 816 beschriebene Vorrichtung erfaßt zum Unterschied von der Erfindung Kommutierungsstörungen mittels einer Detektion des Stromflusses in den Schaltzweigen eines Umrichters. Wenn ein Zweig außerhalb eines zulässigen Zeitbereiches Strom führt, gibt die Schaltung ein Auslösesignal ab. Dabei werden sowohl die zulässigen als auch die unzulässigen Zeitbereiche über eine Synchronisationsschaltung auf die Netzspannungen des Umrichters abgeleitet.

Aufgabe der Erfindung ist es nun, ein Meßverfahren zur vergleichenden Bestimmung des Leistungsfaktors von über einen Umrichter gespeisten Drehstromantrieben verfügbar zu machen, das sich mit einem gegenüber dem Stand der Technik verringerten gerätetechnischen Aufwand bei Umrichtern jeder beliebigen Schaltungsanordnung einsetzen läßt.

Zur Lösung der gestellten Aufgabe soll das aus den Ansprüchen hervorgehende Meßverfahren dienen.

Nachstehend wird die Erfindung anhand der Zeichnungen näher erläutert. Dabei zeigen im einzelnen:

Fig. 1 das Prinzipschaltbild einer erfindungsgemäßen Schaltungsanordnung,

Fig. 2 die in einem Vektorschaubild dargestellten diskreten Spannungszeiger der vom Umrichter abgegebenen Ausgangsspannung,

Fig. 3a und 3b zwei Diagramme über den Stromverlauf im Meßpunkt des Schaltzweiges und den Motorstrom eines von einem Pulsumrichter mit Blockmodulation betriebenen Asynchronmotors,

Fig. 4 eine vereinfachte Schaltungsanordnung für Pulsumrichter mit Blockmodulation, und

Fig. 5 die Schaltungsanordnung für einen Pulsumrichter mit sinusbewerteter Modulation.

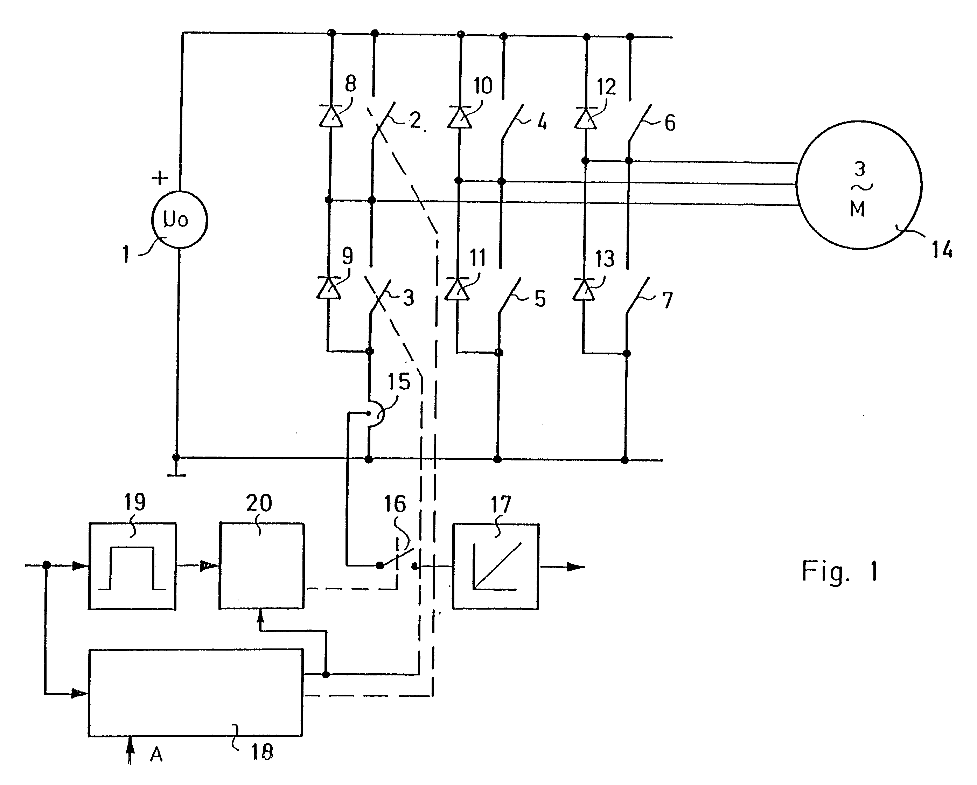

Das aus Fig. 1 hervorgehende Prinzipschaltbild stellt eine Schaltungsanordnung mit einem durch eine Spannungsquelle 1 und sechs Schalter 2, 3, 4, 5, 6 und 7 mit den ihnen jeweils zugeordneten Freilaufdioden 8, 9, 10, 11, 12 und 13 gekennzeichneten Umrichter dar, von dem ein Drehstrommotor 14 gespeist wird. Eine in einem Schaltzweig des Umrichters befindliche Strommeßeinrichtung 15 ist über einen Schalter 16 mit einem Integrator 17 verbunden, dem eine Steuerlogik zugeordnet ist, die aus einem Modulationsteil 18, einem Winkelbereichsschaltwerk 19, eventuell einer Symmetrierlogik und einem Verknüpfungsschaltnetz 20 besteht. Der Ausgang des Integrators 17 bleibt nur bei einem realen, dem Sollwert entsprechenden Leistungsfaktor konstant.

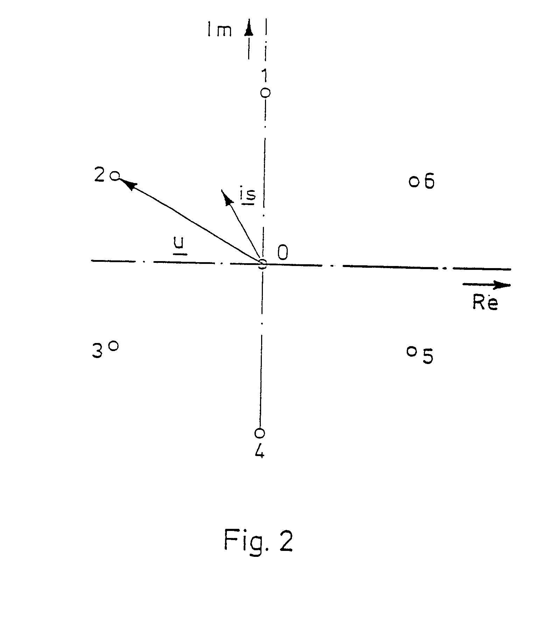

Bei den Schaltungsteilen 2 bis 13 in Fig. 1 handelt es sich um die üblichen Bestandteile eines umrichtergespeisten Drehstrommotors. Die Spannungsquelle 1 besteht in realen Systemen beispielsweise aus einem Zwischenkreis-Kondensator, der von einem Gleichrichter gespeist wird, einer Batterie oder ähnlichem. Die Schalter 2 bis 7 des Umrichters ermöglichen je nach Stellung diskrete Ausgangsspannungswerte, die sich in einem Drehstromsystem als rotierende Zeiger mit diskreten Werten darstellen lassen. Fig. 2 zeigt die sieben diskreten Werte, welche die Ausgangsspannung eines dreiphasigen Umrichters unter Vernachlässigung der transienten Vorgänge im Schaltvorgang annehmen kann. Der Nullvektor wird dabei durch das Schalten aller Phasen auf ein konstantes, also das $U_o$ bzw. das Masse-Potential erreicht. In anderen als dreiphasigen Umrichtern gelten ähnliche Verhältnisse, jedoch mit anderen Zeigerstellungen der möglichen Spannungszeiger. Die Schaltfolge des Umrichters wird durch den Modulator 18 bestimmt. Je nach Modulationsverfahren ergeben sich mehr oder weniger sinusförmige Verläufe des Motorstromes.

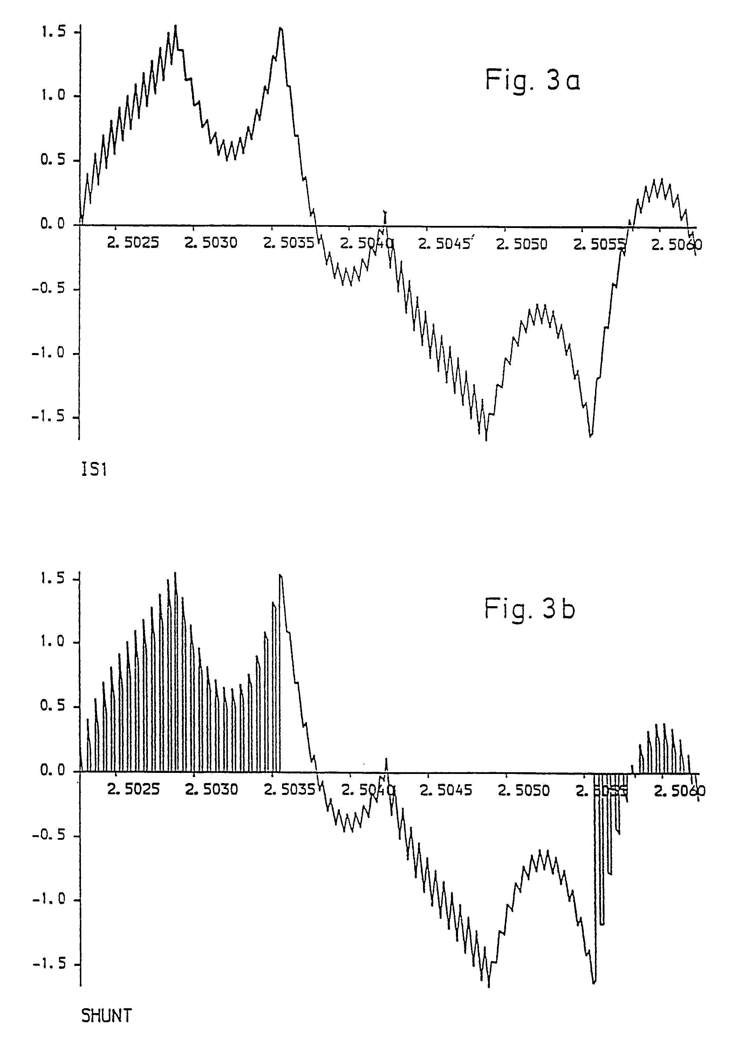

Die Möglichkeiten zur Erfassung des Leistungsfaktors cos-phi aus den an den Motorklemmen meßbaren Größen sind bekannt. Die in Fig. 3a gezeigten Verläufe des Motorstromes lassen erkennen, daß einfache Phasendetektorschaltungen durch die mehrfachen Nulldurchgänge des Stromes für eine Erfassung des Phasenwinkels nicht ausreichen. Erfindungsgemäß wird daher in einem Winkelbereich, der symmetrisch zu dem zu untersuchenden Leistungsfaktorwinkel phi-soll ist, der Strom integriert. Hierdurch erreicht man, daß mit größer werdendem Winkelbereich der Einfluß der Oberschwingung geringer wird. Die Strommessung in der Zuleitung zum Motor ist aufwendig, da sie potentialtrennend ausgeführt werden muß. Erfindungsgemäß wird der Strom nicht in der Motorzuleitung, sondern in einem oder mehreren Schaltzweigen gemessen. Der Schalter führt, wie eine einfache Überlegung und Fig. 3b zeigen, zeitweise den Motorstrom. Durch Integration während geigneter Zeitabschnitte kann nun aus dem durch den Schalter fließenden Strom der Leistungsfaktor bezüglich eines Sollwertes verglichen werden. Der Vorteil der Messung des Stromes in dem Schalter ist die potentialbehaftete Meßmöglichkeit. Hierbei wird sinnvollerweise die Signalelektronik auf dem Potential des Meßpunktes betrieben, womit sich sehr einfache Meßmöglichkeiten des Stromes mit einfachen Widerständen ergeben. Da keinerlei Genauigkeitsanforderungen an die Meßgenauigkeit des Stromes gestellt werden, sondern nur die Symmetriebedingung durch Integration in einem bestimmten Winkelbereich erfüllt sein muß, kann ein einfacher Draht usw. als Meßwiderstand eingesetzt werden.

Die ausreichenden Bedingungen für die Einschaltfunktion des Integrators sind folgende:

1.) Die Integrationszeit muß ungleich dem ganzzahligen Vielfachen der Einschaltzeit für eine Periode, das heißt in praktischen Realisierungen kleiner als eine Periode der Ausgangsfrequenz des Umrichters sein, und

2.) der Integrator 17 darf nur eingeschaltet sein, wenn den betroffenen Schaltzweig 15 Strom durchfließt und gleichzeitig die Schaltfunktion des Integrators 17 zu dem zu überprüfenden Winkel in der Zeitdauer und der Zeitfolge für alle Frequenzen und Amplituden proportional ist.

Diese Bedingungen führen für die verschiedenen Umrichtertypen zu unterschiedlichen Ausführungsformen, die anschließend für die wichtigsten Umrichtertypen beschrieben werden.

Die einfachste Erfassungsschaltung bietet der Umrichter mit variabler Zwischenkreisspannung und blockförmigem Verlauf der Ausgangsspannung. Hierbei wird der Einfachheit halber in einem um den zu prüfenden Phasenwinkel integrierten Bereich, bei dem der Schalter 16 geschlossen ist, gemessen. Damit ist sichergestellt, daß während des Meßvorganges auch dauernd Strom durch den Meßpunkt fließt. Die Symmetriebedingung ist damit in trivialer Weise erfüllt. Als Beispiel für die Erfassung eines Leistungsfaktors von 0,7 - entsprechend ca. 45° Phasenwinkel - eignet sich demnach ein Integrationsbereich von 0° bis 90° des Spannungsverlaufes.

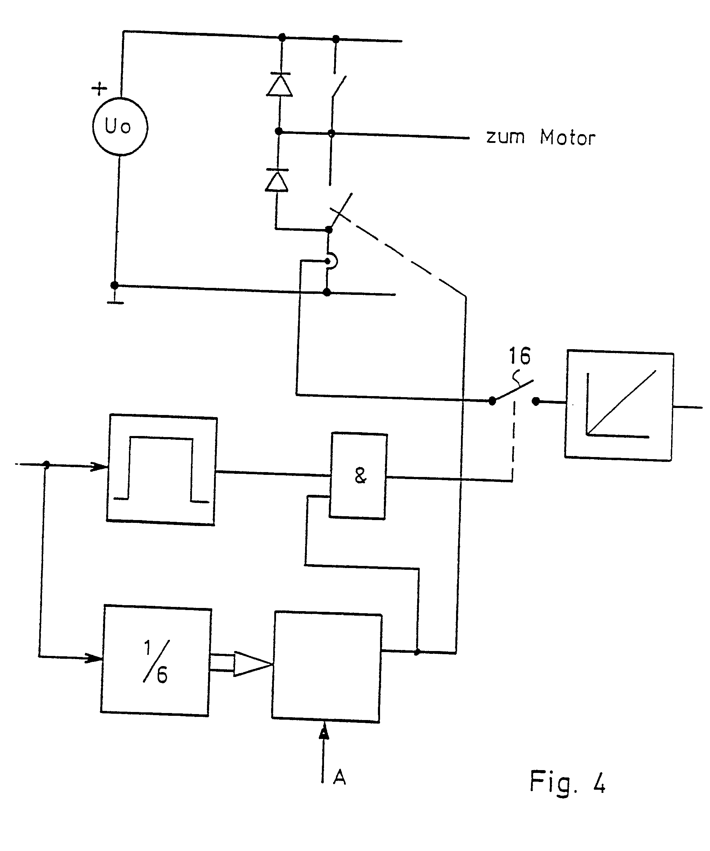

Etwas aufwendiger gestaltet sich die Erfassung des Leistungsfaktors für Umrichter mit fester Zwischenkreisspannung. Bei Umrichtern mit blockförmiger Ausgangsspannung wird die mittlere Amplitude der Ausgangsspannung durch Pulsbreitenmodulation verstellt. Fig. 3b zeigt den Stromverlauf im Meßshunt 15 bei einer derartigen Steuerung des Motors. Dabei wird in diesem Fall der Nullvektor, also die Ausgangsspannung null, durch das Einschalten aller parallel zum Meßzweig befindlichen Schalter 3, 5 und 7 erreicht. Analog zum ersten Beispiel wird hier als zusätzliche Bedingung nicht während des gesamten Meßbereichs, beispielsweise 45° ± 45°, sondern gemäß Fig. 4 nur bei zusätzlich eingeschaltetem Schalter 16 integriert. Der sich daraus ergebende Integrationsbereich kann erweitert werden, wenn als Symmetriefunktion das Einschalten eines Spannungszeigers ungleich dem Nullvektor mit dem Schaltsignal "und" verknüpft wird, was jedoch nur für dieses Beispiel gilt. Jedes andere Modulationsverfahren kann eine andere Symmetriefunktion verlangen.

Beispielsweise ist die Symmetriefunktion für Umrichter mit einer sinusbewerteten Modulation nicht trivial erfüllt, da das Pulsbreitenverhältnis über die Periode variabel ist. Nur bei einigen singulären Leistungsfaktoren, die den Symmetriepunkten der trigonometrischen Funktionen entsprechen, d.h. bei 90° bzw. 180°, ergeben sich dieselben Bedingungen wie für das vorherige Beispiel. Die Symmetriefunktion ist eine weitere Schaltfunktion, die mit der Schaltfunktion des Schalters, in dessen Schaltkreis der Strom gemessen wird, "und" verknüpft wird.

Die einfachste von beliebig vielen Symmetriefunktionen ist die Einführung einer Funktion mit einer konstanten Schaltzeit, die der bezüglich des gewählten Integrationsbereiches kürzesten bestehenden Einschaltzeit des Schalters entspricht und bei jedem Einschalten des Schalters ausgelöst wird.

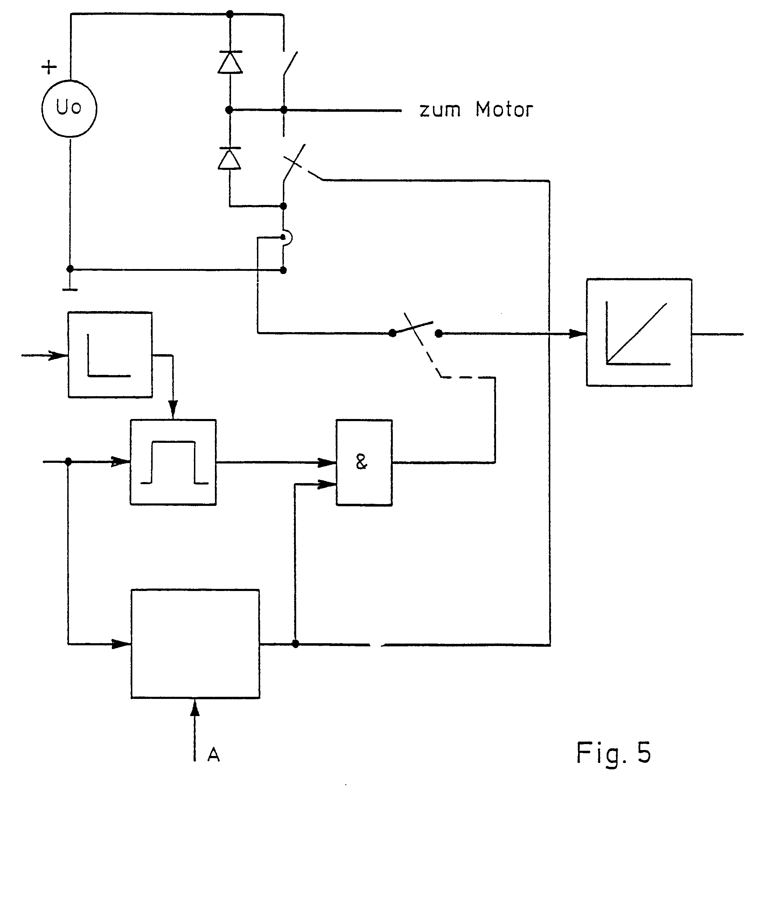

Eine weitere Ausführungsform geht aus Fig. 5 hervor. Hier wird nicht die Meßfunktion symmetriert, sondern der Vergleichswert mit einer der Linearisierung dienenden Funktion beaufschlagt. In realen Systemen wird normalerweise ein fester Phasenwinkel verglichen. Das heißt, es muß nur einmalig der tatsächliche Phasenwinkel mit den üblichen Meßmethoden zu einem bestimmten Integrationsbereich, also nur ein Punkt der Linearisierungsfunktion bestimmt werden.

## Patentansprüche

1. Elektrisches Meßverfahren zur vergleichenden Bestimmung des Leistungsfaktors eines von einer stationären oder ortsveränderlichen Spannungsquelle (1) über einen Umrichter gespeisten Drehstrommotors (14) und einer in wenigstens einem Schaltzweig angeordneten Strommeßeinrichtung (15), die über einen Schalter (16) mit einem Integrator (17) oder ähnlich wirkenden Filter, dessen Ausgangssignal ein Maß für den Leistungsfaktor des Drehstrommotors darstellt, verbunden ist, dadurch gekennzeichnet, daß der gemessene Strom periodisch über elektronische Schalter (2 - 7) dann dem Integrator (17) zugeführt wird, wenn der Schalter (16) des Schaltzweiges geschlossen ist, die Ausgangsspannung zwischen den Klemmen des Umrichters (2 - 13) ungleich null ist und ein vorgegebener Winkelbereich vorliegt, der symmetrisch zu dem zu untersuchenden Leistungsfaktorwinkel phi-soll ist und der kleiner ist als eine Periode der Ausgangsfrequenz des Umrichters (213.

2. Elektrisches Meßverfahren nach Anspruch 1 dadurch gekennzeichnet, daß eine zur Symmetrierung der Einschaltzeit des Integrators (17) bezüglich des zu überprüfenden Phasenwinkelsollwertes dienende Schaltfunktion der elektronischen Schalters vorliegt.

3. Elektrisches Meßverfahren nach Anspruch 1, dadurch gekennzeichnet, daß der Umrichter (2 - 13) eine blockförmige Ausgangsspannung aufweist und die Amplitude dieser Ausgangsspannung durch eine variable Eingangsspannung des Umrichters (2 - 13) bestimmt wird, wobei der Integrationsbereich symmetrisch zum Phasenwinkelsollwert sowie kleiner oder gleich dem Abstand zum Einschaltsignal des Schaltzweiges ist.

4. Elektrisches Meßverfahren nach Anspruch 1, dadurch gekennzeichnet, daß der Umrichter (2 - 13) eine blockförmige Ausgangsspannung aufweist und die Amplitude dieser Ausgangsspannung in ihrem Mittelwert durch Pulsbreitenmodulation mit einem variablen Tastverhältnis bestimmt wird, wobei der Integrationsbereich symmetrisch zum Phasenwinkelsollwert sowie kleiner oder gleich dem Abstand zum Einschaltsignal des Schaltzweiges ist.

5. Elektrisches Meßverfahren nach Anspruch 1 oder 4, dadurch gekennzeichnet, daß die elektronischen Schalter (2 - 7) jeweils über die Und-Verknüpfung des Schaltzustandes des im Schaltzweig angeordneten Schalters (16), den Winkelbereich und das Signal für die Ungleichheit der Ausgangsspannung von null geschaltet werden.

6. Elektrisches Meßverfahren nach Anspruch 2, dadurch gekennzeichnet, daß die elektronischen Schalter (27) jeweils über die Und-Verknüpfung des Schaltzustandes des im Schaltzweig angeordneten Schalters (16), dem Winkelbereich und die Symmetrierung der Schaltzeiten der elektronischen Schalter (2 - 7) bezüglich des zu messenden Phasenwinkels geschaltet werden.

7. Elektrisches Meßverfahren nach Anspruch 3, dadurch gekennzeichnet, daß die elektronischen Schalter (2 - 7) jeweils über die Und-Verknüpfung des Schaltzustandes des im Schaltzweig angeordneten Schalters (16) und den Winkelbereich geschaltet werden.

## Claims

1. Electrical measurement method for the comparative determination of the power factor of a polyphase alternating current motor (14), which is fed from a stationary or mobile voltage source (1) by way of a static inverter, and a current measuring equipment (15), which is arranged in at least one switching branch and connected by way of a switch (16) with an integrator (17) or similarly acting filter, the output of which represents a measure of the power factor of the polyphase alternating current motor, characterised thereby, that the measured current is conducted periodically by way of electronic switches (2 to 7) to the integrator (17) when the switch (16) of the switching branch is closed, the output voltage between the terminals of the static inverter (2 to 13) is equal to zero and a preset angular region is present, which is symmetrical with the power factor angle phi-soll to be examined and smaller than one period of the output frequency of the static inverter (2 to 13).

2. Electrical measurement method according to claim 1, characterised thereby, that a switching function of the electronic switches is present, which serves for making the on-time of the integrator (17) symmetrical with respect to the target phase angle value to be examined.

3. Electrical measurement method according to claim 1, characterised thereby, that the static inverter (2 to 13) displays a block-shaped output voltage and the amplitude of this output voltage is determined by a variable input voltage of the static inverter (2 to 13), wherein the integration range is symmetrical with the target phase angle value as well as smaller than or equal to the spacing from the switch-on signal of the switching branch.

4. Electrical measurement method according to claim 1, characterised thereby, that the static inverter (2 to 13) displays a block-shaped output voltage and the amplitude of this output voltage is determined in its mean value by pulse width modulation with a variable keying ratio, wherein the integration range is symmetrical with the target phase angle value as well as smaller than or equal to the spacing from the switch-on signal of the switching branch.

5. Electrical measurement method according to claim 1 or 4, characterised thereby, that the electronic switches (2 to 7) are switched from zero each time by way of the AND-interlinking of the switching state of the switch (16) arranged in the switching branch, the angular region and the signal for the inequality of the output voltage.

6. Electrical measurement method according to claim 2, characterised thereby, that the electrical switches (2 to 7) are switched each time by way of the AND-interlinking of the switching state of the switch (16) arranged in the switching branch, the angular region and the switching times of the electronic switches (2 to 7) having been made symmetrical with respect to the phase angle to be measured.

7. Electrical measurement method according to claim 3, characterised thereby, that the electronic switches (2 to 7) are switched each time by way of the AND-interlinking of the switching state of the switch (16) arranged in the switching branch and the angular region.

**Revendications**

1. Procédé de mesure électrique pour déterminer comparativement le facteur de puissance d'un moteur à courant alternatif (14), alimenté par une source de tension (1) stationnaire ou mobile, par l'intermédiaire d'un convertisseur de fréquence et d'une installation de mesure de courant (15), placée au moins sur une branche comportant un interrupteur, qui est reliée, par l'intermédiaire d'un interrupteur (16), à un intégrateur (17) ou à un filtre agissant d'une manière analogue, dont le signal de sortie représente une mesure pour le facteur de puissance du moteur à courant alternatif, caractérisé en ce que le courant mesuré est ensuite fourni, par l'intermédiaire d'interrupteurs électroniques (2 - 7) à l'intégrateur (17), quand l'interrupteur (16) de la branche comportant l'interrupteur est fermé, que la tension de sortie entre les bornes du convertisseur de fréquence (2 - 13) est différente de zéro, et que l'on se trouve devant un domaine angulaire donné à l'avance qui est symétrique par rapport à l'angle de consigne phi du facteur de puissance à contrôler et qui est plus petit qu'une période de la fréquence de sortie du convertisseur de fréquence (2 - 13).

2. Procédé de mesure électrique suivant la revendication 1, caractérisé en ce qu'une fonction de commutation de l'interrupteur électronique est pré-déterminée pour rendre symétrique le temps de fonctionnement de l'intégrateur (17), par rapport à la valeur de consigne de l'angle de phase

3. Procédé de mesure électrique suivant la revendication 1, caractérisé en ce que le convertisseur de fréquence (2 - 13) présente une tension de sortie ayant une allure en créneaux et que l'amplitude de cette tension de sortie est déterminée par une tension d'entrée variable du convertisseur de fréquence (2 - 13), le domaine d'intégration étant symétrique par rapport à la valeur de consigne de l'angle de phase, et égal ou plus petit que l'écart au signal d'enclenchement émis par la branche comportant l'interrupteur.

4. Procédé de mesure électrique suivant la revendication 1, caractérisé en ce que le convertisseur de fréquence (2 - 13) présente une tension de sortie ayant une allure en créneaux et que l'amplitude de cette tension de sortie est déterminée, pour sa valeur moyenne, par une modulation de largeur de pulsation comportant un taux d'impulsions variable, le domaine d'intégration étant symétrique de la valeur de consigne de l'angle de phase, et égal ou plus petit que l'écart au signal d'enclenchement émis par la branche comportant l'interrupteur.

5. Procédé de mesure électrique suivant la revendication 1 ou la revendication 4, caractérisé en ce que les interrupteurs électroniques (2 - 7) sont connectés chaque fois par zéro, par l'intermédiaire de l'opérateur "ET" de l'état du circuit de l'interrupteur (16) disposé sur la branche comportant l'interrupteur, par le domaine d'angle et par le signal pour une tension de sortie différente de zéro.

6. Procédé de mesure électrique suivant la revendication 2, caractérisé en ce que les interrupteurs électroniques (2 - 7) sont connectés chaque fois par zéro par l'intermédiaire de l'opérateur "ET" de l'état du circuit de l'interrupteur (16) disposé sur la branche comportant l'interrupteur, par le domaine d'angle et par le fait de rendre symétrique les temps de connexion des interrupteurs électroniques (2 - 7), par rapport à l'angle de phase à déterminer.

7. Procédé de mesure électrique suivant la revendication 3, caractérisé en ce que les interrupteurs électroniques (2 - 7) sont connectés chaque fois par l'intermédiaire de l'opérateur "ET" de l'état du circuit de l'interrupteur (16) disposé sur la branche comportant l'interrupteur et du domaine d'angle.

Fig. 1

Fig. 2

Fig. 3a

IS1

Fig. 3b

SHUNT

zum Motor

16

Fig. 4

A

zum Motor

Fig. 5